# EUROPÄISCHE PATENTSCHRIFT

(11) **EP 2 856 184 B1**
(45) Veröffentlichungstag und Bekanntmachung des Hinweises auf die Patenterteilung: **25.04.2018**
(21) Anmeldenummer: 13716759.9
(22) Anmeldetag: 09.04.2013
(51) Int. Cl.: G01R 31/00

(54) **VORRICHTUNG ZUM TESTEN EINER ELEKTRISCHEN KOMPONENTE**
DEVICE FOR TESTING AN ELECTRIC COMPONENT
DISPOSITIF PERMETTANT DE TESTER UN COMPOSANT ÉLECTRIQUE

(30) Priorität: 01.06.2012 DE 102012104778
(43) Veröffentlichungstag der Anmeldung: 08.04.2015
(73) Patentinhaber: dSPACE digital signal processing and control engineering GmbH, 33102 Paderborn (DE)
(72) Erfinder: HASSE, Dirk, 33154 Salzkotten (DE); POLNAU, Robert, 33098 Paderborn (DE); SCHEIBELHUT, Peter, 33100 Paderborn (DE)
(86) Internationale Anmeldenummer: PCT/EP2013/057338
(87) Internationale Veröffentlichungsnummer: WO 2013/178392

(56) Entgegenhaltungen:
- EP-A2- 2 015 084
- DE-A1-102009 048 981
- DE-A1-102010 043 661
- US-A1- 2001 008 006

## Beschreibung

Die vorliegende Erfindung betrifft eine Vorrichtung zum Testen einer elektrischen Komponente mit einer Simulationseinrichtung zum Erzeugen eines Simulationssignals, einer Mehrzahl von Testeinrichtungen, und wenigstens einer elektrischen Verbindungseinrichtung, wobei die Simulationseinrichtung und die Mehrzahl von Testeinrichtungen mit der wenigstens einen Verbindungseinrichtung elektrisch leitend verbunden oder verbindbar sind.

Eine derartige Vorrichtung zum Testen einer elektrischen Komponente wird häufig auch als "Testvorrichtung" oder als "Simulatorsystem" bezeichnet.

Vorrichtungen zum Testen von elektrischen Komponenten, wie beispielsweise eines Steuerungssystems für ein Kraftfahrzeug oder eine Automatisierungseinrichtung, sind aus dem Stand der Technik in verschiedensten Ausgestaltungen bekannt und werden vor allem in der angewandten Forschung, der industriellen Entwicklung und in sonstigen Einsatzgebieten verwendet, insbesondere in den Bereichen Mechatronik, automotive Anwendungen, in der Luft- und Raumfahrttechnik, in der Anlagen- und Verfahrenstechnik und sonstigen technischen Gebieten, in denen im weitesten Sinne Prozesssteuerungsaufgaben gelöst werden müssen. Insofern wird in diesem Zusammenhang unter einem Steuerungssystem eine technische Einrichtung verstanden, die im Wesentlichen für die Aufgaben Messen, Steuern und/oder Regeln einsetzbar ist. Im weitesten Sinne handelt es sich dabei generell um ein elektrisches, vorzugsweise programmsteuerbares System, das insbesondere im Bereich automotiver Anwendungen üblicherweise "Steuergerät" genannt wird. Insofern ist ein Steuerungssystem nicht nur auf die systemtheoretische Definition einer Steuerung beschränkt, sondern wird üblicherweise auch zur Implementierung von Regelungen eingesetzt.

Im Stand der Technik gemäß der DE 10 2009 048981 A1 ist eine Vorrichtung zum Testen einer elektrischen Komponente, mit einer Simulationseinrichtung zum Erzeugen eines Simulationssignals, einer Testeinrichtung zum Anschließen der elektrischen Komponente, wenigstens zwei Verbindungseinrichtungen und einer Auswahleinrichtung zum Auswählen der Verbindungseinrichtung offenbart. Hierbei könnten die Simulationseinrichtung und die Testeinrichtung mit wenigstens einer der Verbindungseinrichtungen mittels der Auswahleinrichtung elektrisch leitend verbindbar sein, und die einzelnen Verbindungseinrichtungen könnten sich hinsichtlich jeweils wenigstens einer elektrischen Eigenschaft voneinander unterscheiden.

Des Weiteren ist aus einer Veröffentlichung EP 2 015 084 A2 eine Testvorrichtung für elektrische, insbesondere elektronische, Komponenten, mit Testmodulen bekannt, die eine Testanschlussanordnung zum Anschließen einer zu testenden elektrischen Komponente, einen Steueranschluss zum Anschluss einer zentralen Steuerung und mindestens einen über den Steueranschluss betätigbaren Wahlschalter zum wahlweisen Aufschalten mindestens einer Last und/oder mindestens eines Stimulussignals auf Testanschlüsse der Testanschlussanordnung aufweisen, wobei mindestens ein Testmodul eine interne, über den mindestens einen Wahlschalter mit der Testanschlussanordnung verbindbare Stimulationseinrichtung zur Erzeugung mindestens eines Stimulussignals und/oder eine interne, über den mindestens einen Wahlschalter mit der Testanschlussanordnung verbindbare Lasteinrichtung zur Bildung der an die Testanschlussanordnung anzulegenden Last an Bord haben könnte.

Aus dem Stand der Technik bekannte Vorrichtungen zum Testen eines Steuerungssystems weisen vielfach eine Simulationseinrichtung zum Erzeugen, Messen und/oder Analysieren eines Simulationssignals, eine Mehrzahl Testeinrichtungen zum Anschließen des Steuerungssystems und wenigstens eine Verbindungseinrichtung, beispielsweise eine Sammelschiene oder ein Bussystem, auf. Aus dem Stand der Technik sind Sammelschienen bekannt, die einen oder mehrere elektrische Leiter aufweisen, der oder die durch einen Isolator, beispielsweise einen isolierenden Kunststoff und/oder einen Luftspalt, von anderen elektrischen Leitern getrennt ist. Dabei kann die Sammelschiene ein Bestandteil einer gedruckten Leiterplatte sein. Eine gedruckte elektrische Leiterbahn der Leiterplatte kann beispielsweise einerseits teilweise von Kunststoff umgeben und andererseits teilweise durch einen Luftspalt von anderen elektrischen Leitern isoliert sein. Eine Verbindungseinrichtung kann beispielsweise mit zwei einzelnen Leitern ausgeführt sein.

Nachteilig an derartigen Vorrichtungen ist, dass parasitäre Eigenschaften der Verbindungseinrichtung die Simulationssignale stören und/oder verändern. Mit anderen Worten bewirken die parasitären Eigenschaften der Sammelschiene oder des Bussystems eine Verfälschung der Simulation, was also letztendlich zu einem fehlerbehafteten Test des Steuerungssystems führen kann. Testergebnisse können insofern verfälscht werden und zu unrichtigen Resultaten führen.

Zur Fehlersimulation können viele Komponenten mit der Verbindungseinrichtung verbunden sein, wodurch die Verfälschung von Testergebnissen begünstigt wird. Parasitäre Kapazitäten steigen mit der Anzahl an verbundenen Komponenten und können über verschiedene Schaltschränke, auf welche die Vorrichtung verteilt ist, wirken. Auch kann die Unterstützung hoher Ströme in der Verbindungseinrichtung erforderlich sein, weshalb ausreichende Leiterquerschnitte bzw. ausreichende Leiterbahnenbreiten (z.B. bei gedruckten Leiterplatten) für die Verbindungseinrichtung zu wählen sind. Weiterhin nimmt die Verwendung von Leistungshalbleitern mit vergleichsweise zeitlich präzise definiertem Schaltverhalten zu. Beide, also Leiterbahnen für hohe Ströme und Leistungshalbleiter, begünstigen das Auftreten von parasitären Kapazitäten, die bei empfindlichen Signalen störend wirken können. Die parasitäre Kapazität der Sammelschienen steigt dabei in der Regel mit der Anzahl miteinander verbundener Komponenten.

Eine Fehlersimulation kann sowohl auf der Ebene eines Einzelsteuergeräts als auch im Verbund gewünscht sein. Dabei ist jeweils der Aufbau der Vorrichtung an den jeweiligen Test anzupassen. Ein generischer Testaufbau ist nur eingeschränkt möglich, da der Aufbau selbst, insbesondere die Verbindungseinrichtung, die Testergebnisse weiter verfälschen kann. Auch ist ein Test mehrerer Einzelsteuergeräte gleichzeitig und unabhängig voneinander mit einem solchen Aufbau nur nach einer entsprechenden Konfiguration möglich. Beispielsweise können Komponenten in verschiedenen Racks zu einem Testaufbau verbunden werden.
In diesem Fall sind gleichzeitige und unabhängige Fehlersimulation in den verschiedenen Racks nicht möglich.
Beispiele für ein Rack sind ein Schaltschrank oder ein sogenannter 19-Zoll-Schrank. Ein Rack kann in der Regel mehrere sogenannte Subracks umfassen, wobei die Subracks beispielsweise als sogenannte Baugruppenträger, bevorzugt als sogenannte 19-Zoll-Baugruppenträger, ausgestaltet sein können.

Zum Testen einer elektrischen Komponente können verschiedenartige Simulationssignale verwendet werden. Daher können über die Verbindungseinrichtung zu führenden Signale nahezu beliebig ausgestaltet sein und reichen von kleinen Sensorsignalen, nachfolgend auch als "Lowlevel" bezeichnet, bis hin zu großen Aktorsignalen, nachfolgend auch als "Highlevel" bezeichnet.
Eine begriffliche Zuordnung der Sensorsignale zu Highlevel oder Lowlevel kann je nach Ausgestaltung der Testvorrichtung unterschiedlich sein. Beispielsweise kann definiert sein, dass alle Signale, die einen maximalen elektrischen Spannungsbetrag Umax ≤ 10 mV und/oder die einem maximalen elektrischen Strombetrag Imax ≤ 10 mA aufweisen, zur Gruppe der Lowlevel-Signal zuzuordnen sind. Ein beispielhafte Festlegung für die Gruppe der Highlevel-Signale kann definieren, dass alle Signale, die eine einen maximalen elektrischen Spannungsbetrag Umax ≥ 5 V und/oder die einen maximalen elektrischen Strombetrag Imax ≥ 100 mA aufweisen, zur Gruppe der Highlevel-Signal zuzuordnen sind.
In diesem aufgezeigten Beispiel können die Signale, die betraglich größer als Lowlevel-Signale sind, aber betraglich kleiner als Highlevel-Sinale gemäß der oben genannten beispielhaften Festlegung sind, bevorzugt dennoch der Gruppe der Highlevel-Signale zugeordnet werden. Der Highlevel-Bereich und der Lowlevel-Bereich können prinzipiell beliebig definiert werden, wobei aber der Highlevel-Bereich stets die größeren Werte (Spannung, Strom und/oder Leistung) als der Lowlevel-Bereich aufweist.

Eine technische Trennung der Signale nach High- und Lowlevel ist in der Regel nicht sinnvoll möglich, beispielsweise weil Randbedingungen zum Zeitpunkt der Projektierung der Vorrichtung nicht bekannt sind, oder eine testweise kurzzeitige Realisierung eines Kurzschlusses eines Highlevel-Signals zum Lowlevel-Signal explizit gefordert ist, beispielsweise um mittels der Testvorrichtung für eine zu testende elektrische Komponente entsprechende technische Randbedingungen im Fehlerfall zu simulieren.

Ausgehend von dem oben genannten Stand der Technik liegt der Erfindung somit die Aufgabe zugrunde, eine Vorrichtung zum Testen einer elektrischen Komponente anzugeben, die verbesserte Testergebnisse liefert und eine einfache Durchführung der Tests ermöglicht.

Die Lösung der Aufgabe erfolgt erfindungsgemäß durch die Merkmale des unabhängigen Anspruchs. Vorteilhafte Ausgestaltungen der Erfindung sind in den Unteransprüchen angegeben.

Erfindungsgemäß ist somit eine Vorrichtung zum Testen einer elektrischen Komponente angegeben. Die Vorrichtung ist ausgeführt mit einer Simulationseinrichtung zum Erzeugen eines Simulationssignals einer Mehrzahl Testeinrichtungen, und einer Mehrzahl elektrischer Verbindungseinrichtungen, wobei die Simulationseinrichtung und die Mehrzahl Testeinrichtungen mit den Verbindungseinrichtungen elektrisch leitend verbunden oder verbindbar
sind, wobei die Verbindungseinrichtungen jeweils wenigstens eine elektrische Schalteinrichtung aufweisen, die derart angeordnet sind, um eine elektrische Verbindung zwischen der Mehrzahl Testeinrichtungen über die entsprechende Verbindungseinrichtung zu unterbrechen bzw. zu verbinden, wobei die Verbindungseinrichtungen und die Schalteinrichtungen jeweils integral als eine Funktionseinheit ausgestaltet sind, und wobei
die Mehrzahl elektrischer Verbindungseinrichtungen,
sich hinsichtlich jeweils wenigstens einer elektrischen Eigenschaft voneinander unterscheiden, und die Vorrichtung eine Auswahleinrichtung zum Auswählen einer elektrischen Verbindung der Simulationseinrichtung und der Mehrzahl Testeinrichtungen (4) mit einer der Verbindungseinrichtungen umfasst.

Grundidee der vorliegenden Erfindung ist es also, die wenigstens eine Verbindungseinrichtung zu unterbrechen, so dass die Anzahl an mit der Verbindungseinrichtung verbundenen Testeinrichtungen sowie die Ausdehnung der Verbindungseinrichtung selbst beschränkt werden. Die Beschränkung kann auf ein dem jeweiligen Simulationssignal angepasstes Maß erfolgen. Dadurch werden insbesondere parasitäre Kapazitäten, die in der Verbindungseinrichtung auftreten können, reduziert. Eine Rückwirkung von Teilen der Verbindungseinrichtung oder nicht verwendeten Testeinrichtungen, beispielsweise in Form einer Signalverfälschung eines Simulationssignals wird vermieden oder zumindest verringert. Die wenigstens eine Schalteinrichtung ist ein Bestandteil der Verbindungseinrichtung und bewirkt eine Unterbrechung innerhalb der Verbindungseinrichtung, um einzelne Teile der Verbindungseinrichtung und damit vorzugsweise Testeinrichtungen miteinander und mit der Simulationseinrichtung zu verbinden. Entsprechend können auch mehrere Einzelsteuergeräte gleichzeitig und unabhängig voneinander getestet und Testeinrichtungen in der Vorrichtung isoliert werden. Bei der Ausgestaltung der Vorrichtung mit einer Verbindungseinrichtung wird diese vorzugsweise fest mit der Simulationseinrichtung und den Testeinrichtungen verbunden. Bevorzugt sind die Verbindungseinrichtung, die Simulationseinrichtung und einige der Testeinrichtungen innerhalb der Vorrichtung angeordnet und bilden vorzugsweise mit der Vorrichtung eine bauliche Einheit, beispielsweise in Form eines Racks oder mehrere verbundener Racks.
Die wenigstens eine Schalteinrichtung kann beliebig betätigt werden. Beispielsweise kann eine Steuerungseinrichtung der Vorrichtung alle Schalteinrichtungen zentral schalten. Alternativ und/oder zusätzlich können alle oder einige Schalteinrichtungen dezentral geschaltet werden. Auch können die Schalteinrichtungen für eine manuelle Betätigung ausgeführt sein. Die Schalteinheiten sind beliebig nach der Art eines Öffners oder eines Schließers ausführbar.

Grundsätzlich kann die Testeinrichtung beliebig ausgestaltet sein. Gemäß einer bevorzugten Weiterbildung der Erfindung ist jedoch vorgesehen, dass die Testeinrichtung einen Anschluss für einen Sensor, einen Aktor und/oder ein Steuergerät aufweist. Beispielsweise kann der Sensor als ein Originalsensor eines Kraftfahrzeugs, wie ein Regensensor, und der Aktor beispielsweise als eine Original-Last, beispielsweise als ein elektromechanisches Servolenksystem, also als ein "electric power assisted steering system" bzw. EPAS-System, insbesondere umfassend einen programmgesteuerten Elektrostellmotor, ausgeführt sein. Ferner kann die Testeinrichtung als Teil eines I/O-Geräts ausgestaltet sein. Zu I/O-Geräten zählen insbesondere derartige Geräte mit analogen und digitalen Ein- und Ausgabekanälen, Geräte mit intelligenter Signalverarbeitung zum Vor- und Nachbearbeiten, oft als Pre- und Postprocessing bezeichnet, von Rohdaten, sonstigen Daten, Datenbusmodule, Geräte zur Signalkodierung, oder beispielsweise Module zur Ansteuerung von Aktoren, also Aktoren insbesondere im Sinne von Stellgliedern innerhalb einer Regelstrecke.

Aufgrund der verschiedenen elektrischen Eigenschaften der Verbindungseinrichtungen weisen diese unterschiedliche parasitäre Eigenschaften auf. Eine Signalverfälschung aufgrund der parasitären Eigenschaft kann somit auf das Simulationssignal angepasst werden, so dass dieses nur geringfügig von der parasitären Eigenschaft abhängig ist. Ungewollte Veränderungen des Simulationssignals aufgrund von Kriechströmen, Kapazitäten, Induktivitäten oder Leistungsverlusten, beispielsweise aufgrund einer Eigenschaft eines elektrischen Leiters und/oder dessen Isolation, können reduziert oder im Wesentlichen vermieden werden. Zu der parasitären Eigenschaft einer Verbindungseinrichtung werden insbesondere auch eine unzureichende Durchschlagfestigkeit bzw. eine unzureichende Spannungsfestigkeit gezählt, die im Wesentlichen vom Material, Stoff und/oder Geometrie, also beispielsweise der Dicke eines Isolators abhängt, der den elektrischen Leiter umgibt. Die Auswahleinrichtung kann beispielsweise als Schalter ausführbar sein. Vorzugsweise erfolgt die Auswahl der Verbindungseinrichtung mittels der Auswahleinrichtung aufgrund eines vorgebbaren Parameters, wie beispielsweise aufgrund einer Tabelle, aufgrund einer Messung und/oder mittels eines Computerprogramms, um ein möglichst wenig gestörtes Signal zu erhalten.

In vorteilhafter Ausgestaltung der Erfindung ist vorgesehen, dass eine Mehrzahl elektrischer Schalteinrichtungen der Mehrzahl Verbindungseinrichtungen gemeinsam als Schalteinheit ausgeführt sind. Somit kann unabhängig von der gewählten Verbindungseinrichtung durch die Betätigung einer einzelnen Schalteinheit ein gewünschter Bereich der Verbindungseinrichtung mit damit verbundenen Testeinrichtungen verbunden oder getrennt werden. Kenntnisse über die gewählte Verbindungseinrichtung sind nicht erforderlich.

In vorteilhafter Ausgestaltung der Erfindung ist vorgesehen, dass die wenigstens eine Schalteinrichtung zumindest eine elektrische Eigenschaft aufweist, die an zumindest eine elektrische Eigenschaft der die Schalteinrichtung umfassenden Verbindungseinrichtung angepasst ist. Beispielsweise können Verbindungseinrichtungen für hohe Ströme, also für Highlevel-Ströme, mit Schalteinrichtungen ausgeführt sein, die diese hohen Ströme tragen können. Andererseits können Verbindungseinrichtungen für kleine Ströme, also für Lowlevel-Ströme, mit entsprechenden Schalteinrichtungen für kleine Ströme ausgeführt sein. So haben beispielhafte handelsübliche Schaltschütze für 30V und 30A typischerweise 5V bzw. 100mA als untere spezifizierte Grenzwerte der Schaltspannung bzw. des Schaltstroms. Signale unterhalb dieser Grenzwerte können über ein solches Schütz nicht zuverlässig übertragen werden. Entsprechend wird verhindert, dass ungeeignete Schalteinrichtungen zusätzliche Fehler in dem Simulationssignal bewirken.

Vorzugsweise ist eine Baueinheit gebildet, welche die wenigstens eine Verbindungseinrichtung und die wenigstens eine Schalteinrichtung umfasst.

In einer weiteren vorteilhafter Ausgestaltung der Erfindung ist vorgesehen, dass die Vorrichtung ausgeführt ist, die wenigstens eine Schalteinrichtung lastfrei und/oder spannungsfrei zu schalten. Somit ist keine besondere Schaltfestigkeit der Schalteinrichtung vorzusehen, wodurch einfache und kostengünstige Schalteinrichtungen verwendet werden können. Beispielsweise kann die Vorrichtung vor der Durchführung eines Tests durch Schalten der Schalteinrichtungen konfiguriert werden. Erst bei der Durchführung des Tests werden Signale über die Verbindungseinrichtung und damit die Schalteinrichtungen übertragen.

In einer besonders vorteilhafter Ausgestaltung der Erfindung ist vorgesehen, dass die wenigstens eine elektrische Verbindungseinrichtung hierarchisch in wenigstens zwei Ebenen angeordnet ist, und die wenigstens eine Schalteinrichtung angeordnet ist, eine Verbindung zwischen zwei Ebenen zu unterbrechen bzw. zu verbinden. Dadurch wird eine einfache Zuordnung und Verbindung von Testeinrichtungen ermöglicht. Beispielsweise kann die Vorrichtung auf mehrere Racks als eine Ebene verteilt sein, von denen jedes mehrere Subracks als weitere Ebene enthält. Jedes Subrack kann wiederum einzelne Module umfassen, welche eine dritte Ebene bilden.

In vorteilhafter Ausgestaltung der Erfindung ist vorgesehen, dass die wenigstens eine Schalteinrichtung einen Halbleiterschalter umfasst. Der Halbleiterschalter, beispielsweise ein Transistor, kann einfach oder beispielsweise mehrfach in Reihe geschaltet ausgeführt sein und ermöglicht eine Vielzahl Schaltvorgänge mit guter Zuverlässigkeit. Halbleiterschalter sind üblicherweise zeitlich präziser schaltbar als elektromechanische Schalter.

In einer weiteren vorteilhafter Ausgestaltung der Erfindung ist vorgesehen, dass der Halbleiterschalter einen MOSFET umfasst. Der MOSFET ermöglicht ein effizientes und zeitlich präzises Schalten und weist geringe Verluste auf. Im Vergleich zu einem elektromechanischen Schalter, wie beispielsweise einem Relais oder einem Schütz, ist der MOSFET üblicherweise weniger anfällig für Verschleiß, weil der MOSFET beim Auftrennen eines Stromkreises üblicherweise keinen Abrissfunken erzeugt. MOSFETs, insbesondere sogenannte Leistungs-MOSFETs sind auch für das Durchleiten großer Ströme geeignet.

In einer besonders vorteilhafter Ausgestaltung der Erfindung ist vorgesehen, dass der Halbleiterschalter eine Reihenschaltung aus zwei MOSFETs umfasst, die im Wesentlichen baugleich ausgeführt sind, wobei jeder MOSFET eine Body-Diode aufweist, und der Halbleiterschalter derart ausgestaltet ist, dass die Durchlassrichtung der Body-Dioden der beiden MOSFETs entgegengesetzt zu einander ist. Entsprechend kann die Schalteinrichtung jede Stromrichtung einzeln schalten. Die Bodydiode ist integraler Bestandteil des jeweiligen MOSFETs.

In vorteilhafter Ausgestaltung der Erfindung ist vorgesehen, dass die wenigstens eine Schalteinrichtung einen elektromechanischen Schalter aufweist. Der elektromechanische Schalter ist bevorzugt zur Durchleitung hoher Ströme geeignet. Der besondere Vorteil der Verwendung eines elektromechanischen Schalters in der Schalteinrichtung ist, dass der elektromechanische Schalter im Vergleich zum Halbleiterschalter keine Body-Diode aufweist, und somit die Stromrichtung für den elektromechanischen Schalter in der Regel bedeutungslos ist. Ein weiterer Vorteil des elektromechanischen Schalters ist, dass dessen parasitäre Kapazität im Wesentlichen vernachlässigbar ist.

In einer weiteren vorteilhafter Ausgestaltung der Erfindung ist vorgesehen, dass wenigstens eine Testeinrichtung mit einem elektronischen Steuergerät verbunden ist. Im weiteren Text wird das "elektronische Steuergerät" abgekürzt als "Steuergerät" bezeichnet. Das Steuergerät stellt eine zu testende elektrische Komponente dar. Das Steuergerät ist insbesondere als ein Steuergerät eines Kraftfahrzeugs, eines Schienenfahrzeugs, eines Flugobjekts und/oder einer Automatisierungsvorrichtung ausgestaltet. Derartige Steuergeräte werden im Stand der Technik vielfach als "Electronic Control Unit", abgekürzt ECU, insbesondere als ein automotives ECU bezeichnet. Die Bezeichnung "elektrische" Komponente und "elektrisches" Steuergerät schließt nicht aus, dass neben elektrischen, insbesondere elektronischen, Bauelementen beispielsweise auch optische Bauelemente und/oder opto-elektronische Bauelemente in der elektrischen Komponente bzw. in dem Steuergerät enthalten sind.

In vorteilhafter Ausgestaltung der Erfindung ist vorgesehen, dass die Simulationseinrichtung integral mit wenigstens einer Testeinrichtung ausgeführt ist. Entsprechend kann ein Modul gebildet werden, welches verschiedene Funktionalitäten beinhalten kann und somit für verschiedene Anwendungen verwendbar ist. Zur Verbindung weist das Modul Signalausgänge und/oder Signaleingänge auf.

In vorteilhafter Ausgestaltung der Erfindung ist vorgesehen, dass die wenigstens eine Schalteinrichtung eine Parallelschaltung einer Mehrzahl Schaltelemente aufweist. Dies ermöglicht es, ein Signal über die Mehrzahl Schaltelemente durchzuleiten, wodurch die parasitären Verluste insgesamt reduziert werden. Bei der Auswahl eines geeigneten Schalters sind ein sogenannter Leistungs-MOSFET oder ein Schütz für große Schaltleistungen bevorzugt.
Schütze, auch Schaltschütze genannt, weisen in der Regel eine gute Sperrdämpfung und einen vernachlässigbar-geringen Leckstrom auf. Allerdings ergeben sich relativ hohe Anforderungen in Bezug auf die minimale Schaltspannung und -strom. So haben handelsübliche Schaltschütze für 30V und 30A beispielsweise in der Regel 5V als minimalen Wert der Schaltspannung und 100mA als minimale Wert des Schaltstroms. Signale unterhalb dieser Grenzwerte können mit einem solchen Bauteil nicht zuverlässig verbunden werden. Ein weiterer Kritikpunkt im sogenannten Hochleistungsbereich sind die vergleichsweise großen Bauformen (z.B. der Schaltschütze) sowie die teilweise sehr hohen Anschaffungskosten und die hohe Ansteuerleistung. Vorliegend verteilt sich ein Signalstrom auf alle Schaltelemente der Parallelschaltung, so dass in der Summe große Ströme, also Highlevel-Ströme durch die Parallelschaltung der Mehrzahl Schaltelemente durchgeleitet werden kann. Dabei kann jedes Schaltelement kleiner als ein einzelnes mit gleicher Schaltleistung ausgeführt sein, wodurch die erwähnten Nachteile reduziert werden. Auch sind beispielsweise Schalteinrichtungen mit einer Mehrzahl einzelner Schaltelemente, die jeweils einzeln für Lowlevel-Ströme ausgelegt sind oft kostengünstiger zu realisieren als mit einem einzelnen Schaltelement, das für Highlevel-Ströme ausgelegt ist.

In vorteilhafter Ausgestaltung der Erfindung ist vorgesehen, dass die Vorrichtung ausgeführt ist, die Schaltelemente einer Schalteinrichtung gemeinsam zu steuern. Die Schaltelemente können beispielsweise über eine gemeinsame Schaltspannung steuerbar sein. Es wird somit auf einfache Weise sichergestellt, dass alle Schaltelemente jeweils den gleichen Schaltzustand aufweisen. Die Ansteuerung kann von einer zentralen Steuerungseinrichtung oder lokal, beispielsweise über die Schalteinrichtung selber, erfolgen.

In vorteilhafter Ausgestaltung der Erfindung ist vorgesehen, dass die wenigstens eine Schalteinrichtung ein Schaltelement zum Durchleiten von kleinen Signalen, also zum Durchleiten von Lowlevel-Signalen, aufweist. Als kleines Signal werden Signale mit Spannungen von nicht mehr als einigen 10 Volt und Strömen von weniger als 10 A betrachtet. Das Durchleiten betrifft insbesondere einen geschlossenen Zustand der Schalteinrichtung, da kleine Signale bei der Verwendung von ungeeigneten Schaltelementen auch im geschlossenen, also durchleitenden Zustand nicht oder nicht zuverlässig weitergeleitet werden können.

In vorteilhafter Ausgestaltung der Erfindung ist vorgesehen, dass die wenigstens eine Schalteinrichtung ein Strombegrenzungselement aufweist, das dem Schaltelement zum Durchleiten von kleinen Signalen zugeordnet ist. Das Strombegrenzungselement kann beispielsweise als Sicherung ausgeführt sein, um eine Beschädigung des Schaltelements zu verhindern.

In vorteilhafter Ausgestaltung der Erfindung ist vorgesehen, dass die wenigstens eine Schalteinrichtung eine Mehrzahl von Schaltelementen zum Durchleiten von kleinen Signalen aufweist. Dadurch kann einerseits ein kleines Signal zuverlässig durchgeleitet werden, während andererseits auch große Signale, insbesondere große Ströme, durch die parallelen Schaltelemente gemeinsam durchgeleitet werden können. Vorzugsweise ist jedem der Schaltelemente ein Strombegrenzungselement zugeordnet.

In vorteilhafter Ausgestaltung der Erfindung ist vorgesehen, dass die wenigstens eine Schalteinrichtung ausgeführt ist, eine gleichmäßige Verteilung oder eine im Wesentlichen gleichmäßige Verteilung eines Signalstroms auf die Mehrzahl Schaltelemente zu bewirken. Somit wird sichergestellt, dass keine der Schalteinrichtungen allein durch eine ungleichmäßige Verteilung der Ströme beschädigt werden kann. Vorzugsweise kann die gleichmäßige Stromverteilung durch ein geeignetes Leiterplatten-Layout bewirkt werden. Alternativ und/oder zusätzlich können Elemente, die einen positiven Temperaturkoeffizienten des elektrischen Widerstands aufweisen, also beispielsweise sogenannte Bauelemente mit PTC (positive temperature coeffizient) -Charakteristik aufweisen, verwendet werden, wie beispielsweise Sicherungen, beispielsweise selbstrückstellende Sicherungen auf Polymerbasis (sogenannte PPTC-Sicherungen) oder Leiterzüge mit PTC-Charakteristik.

In vorteilhafter Ausgestaltung der Erfindung ist vorgesehen, dass die wenigstens eine Schalteinrichtung ein Schaltelement zum Durchleiten von großen Signalen aufweist. Große Signale, also Highlevel-Signale, sind beispielsweise Aktorsignale, um eine Betätigung zu bewirken. Die Betätigung kann beispielsweise das Bewegen eines via Elektromotor angetriebenen Hebels sein oder das Öffnen eines Hydraulik-Ventils. Derartige große Signale können somit beispielsweise Ströme von mehreren Ampere und Spannungen, die beispielsweise größer als 12 Volt sind, aufweisen, konkreter beispielsweise 30V und 30A. Entsprechend können große Signale zuverlässig durch die Schalteinrichtung fließen.

In vorteilhafter Ausgestaltung der Erfindung ist vorgesehen, dass die wenigstens eine Schalteinrichtung ein Schaltelement zum Durchleiten von kleinen Signalen und ein Schaltelement zum Durchleiten von großen Signalen aufweist. Entsprechend erfolgt eine Kombination, um mit einer Schalteinrichtung sowohl kleine wie auch große Signale durchleiten zu können. Auch können jeweils mehrere Schaltelemente zum Durchleiten von kleinen bzw. großen Signalen kombiniert werden.

In vorteilhafter Ausgestaltung der Erfindung ist vorgesehen, dass wenigstens ein Schaltelement einen Halbleiterschalter umfasst. Der Halbleiterschalter, beispielsweise ein Transistor, kann einfach ausgeführt sein und ermöglicht eine Vielzahl Schaltvorgänge mit guter Zuverlässigkeit.

In vorteilhafter Ausgestaltung der Erfindung ist vorgesehen, dass der Halbleiterschalter wie zuvor beschrieben ausgestaltet ist. Entsprechend kann jedes einzelne Schaltelement mit einem MOSFET oder einer Reihenschaltung von zwei MOSFETs ausgeführt sein, wobei die zwei MOSFETs bevorzugt derart in Reihe geschaltet sind, dass die Body-Diode des ersten MOSFET der Reihenschaltung entgegengesetzt gerichtet ist zur Body-Diode des zweiten MOSFET des Reihenschaltung.

In vorteilhafter Ausgestaltung der Erfindung ist vorgesehen, dass wenigstens ein Schaltelement als elektromechanischer Schalter ausgeführt ist. Entsprechende Schalter können beispielsweise Relais oder Schütze sein, die als solche bekannt sind. Schütze sind üblicherweise zum Schalten und Durchleiten von großen Strömen ausgelegt und weisen eine hohe Durchschlagfestigkeit auf. Diese Eigenschaften gelten auch für ein Relais, das für Highlevel-Anwendungen ausgelegt sind.

Nachfolgend wird die Erfindung unter Bezugnahme auf die anliegende Zeichnung anhand bevorzugter Ausführungsformen näher erläutert.

Es zeigen
- Fig. 1: eine schematische Darstellung einer Vorrichtung zum Testen einer elektrischen Komponente gemäß einer ersten Ausführungsform der Erfindung,
- Fig. 2: eine Detaildarstellung eines Einzelschalters einer Schalteinrichtung der Vorrichtung aus Fig. 1,
- Fig. 3: eine Detaildarstellung eines Einzelschalters einer Schalteinrichtung der Vorrichtung aus Fig. 1 gemäß einer ersten abgewandelten Ausführungsform,
- Fig. 4: eine Detaildarstellung eines Einzelschalters einer Schalteinrichtung der Vorrichtung aus Fig. 1 gemäß einer zweiten abgewandelten Ausführungsform,
- Fig. 5: eine Detaildarstellung eines Einzelschalters einer Schalteinrichtung der Vorrichtung aus Fig. 1 gemäß einer dritten abgewandelten Ausführungsform, und
- Fig. 6: eine schematische Darstellung einer Vorrichtung zum Testen einer elektrischen Komponente gemäß einer zweiten Ausführungsform der Erfindung.

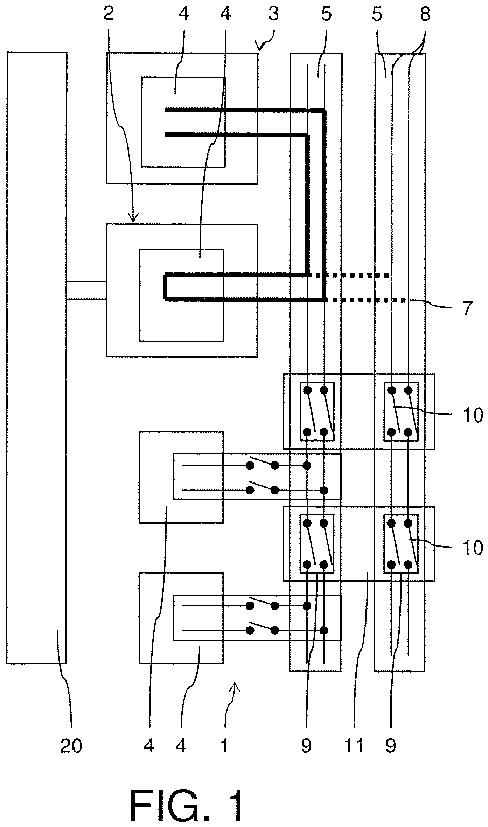

Aus Fig. 1 ist eine Vorrichtung 1 zum Testen einer elektrischen Komponente 20, wie beispielsweise eines Steuergerätes bzw. Steuerungssystems für ein Kraftfahrzeug oder eine Automatisierungseinrichtung, gemäß einer ersten Ausführungsform der Erfindung in einer schematischen Darstellung ersichtlich. Die Vorrichtung 1 weist eine Simulationseinrichtung 2 und eine Routingeinrichtung 3 auf, die bevorzugt jeweils intern eine Testeinrichtung 4 umfassen. Weiterhin umfasst die Vorrichtung 1 gemäß der bevorzugten Ausführungsform zwei separate Testeinrichtungen 4.

Mit der Simulationseinrichtung 2 ist ein Simulationssignal erzeugbar und/oder veränderbar und damit insbesondere ein fehlerfreier und/oder ein fehlerbehafteter Betriebszustand der elektrischen Komponente simulierbar und/oder ein fehlerfreier und/oder ein fehlerbehafteter Betriebszustand einer technischen Umgebung der elektrischen Komponente simulierbar, wobei diese technische Umgebung bevorzugt elektrische Signale an die elektrische Komponente übermittelt und/oder von der elektrischen Komponente empfängt. Das Simulationssignal kann einen Strom und/oder einer Spannung aufweisen, wobei zusätzlich ein resistiver Anteil, ein kapazitiver Anteil, ein induktiver Anteil und/oder ein Frequenzanteil in dem Strom und/oder in der Spannung enthalten sein können. Vorliegend umfasst die Simulationseinrichtung 2 eine Fehlereinbringungseinheit, auch als Failure Insertion Unit, kurz FIU, bezeichnet. Ferner kann das Simulationssignal ein Kurzschluss sein, wie in Fig. 1 angedeutet ist. Beispielsweise können zwei Simulationssignale mittels zeitlich begrenztem Kurzschluss einer ersten Signalleitung, die ein erstes Signal trägt, zu einer zweiten Signalleitung, die ein zweites Signal trägt, gegenseitig beeinflusst werden.

Die Testeinrichtungen 4 dienen insbesondere zum Anschließen der elektrischen Komponente 20, vorzugsweise über die Simulationseinrichtung 2, wie in Fig. 1 gezeigt. Dabei kann jede Testeinrichtung 4 einen Sensor und/oder ein Sensorsystem und/oder einen Aktor und/oder ein Aktorsystem aufweisen. Im vorliegenden Beispiel ist eine Testeinrichtung 4 als Aktor oder Aktorsystem ausgeführt, und mit dem Steuergerät 20 eines nicht gezeigten Kraftfahrzeugs verbunden, während eine andere Testeinrichtung 4 als Sensor oder Sensorsystem ausgeführt ist.

Wie weiterhin aus Fig. 1 ersichtlich, sind die Simulationseinrichtung 2, die Routingeinrichtung 3 und die Testeinrichtungen 4 mit zwei der Verbindungseinrichtungen 5 elektrisch leitend verbindbar. Dabei ist die Simulationseinrichtung 1 mit jeder der Verbindungseinrichtungen 5 verbindbar, wie durch die gestrichelten Linien 7 angedeutet ist.

Wie in Fig. 1 dargestellt ist die Vorrichtung 1 derart konfiguriert, dass die Simulationseinrichtung 2, die Routingeinrichtung 3 und die Testeinrichtungen 4 mit der gleichen Verbindungseinrichtung 5 elektrisch leitend verbunden sind. Durch eine nicht dargestellte Auswahleinrichtung, welche mit einer Mehrzahl Relais ausgeführt ist, können die Simulationseinrichtung 2, die Routingeinrichtung 3 und die Testeinrichtungen 4 mit einer anderen Verbindungseinrichtung 5 elektrisch leitend verbunden werden.

Die Routing-Einrichtung 3 ist bevorzugt als ein schaltbares elektrisches Verbindungsmittel ausgestaltet, mit dem zumindest ein vordefinierter Kanal mittels eines Schalters oder mehrerer Schalter mit einer dem Kanal zuweisbaren Verbindungseinrichtung 5, bspw. einer Sammelschiene für die Fehlersimulation, elektrisch leitend verbindbar sind. Der Kanal bzw. die Kanäle ist bzw. sind zudem bevorzugt mit zumindest einer Signalquelle zur Bereitstellung zumindest eines Simulationssignals und/oder mit zumindest einer Signalsenke zum Empfang zumindest eines Simulationssignals verbunden. Die Signalquellen und Signalsenken sind außerdem bevorzugt von der Testeinrichtung 4 und/oder der Simulationseinrichtung 2 umfasst. Jeder Kanal, der mit einer Signalquelle oder einer Signalsenke verbunden ist, ist ein Mittel zur Weiterleitung von analogen oder digitalen Simulationssignalen über eine räumliche Distanz.

Die Verbindungseinrichtungen 5 sind vorliegend jeweils als Sammelschiene mit zwei elektrischen Leitern 8 ausgeführt, wobei die Verbindungseinrichtung 5 und die Schalteinrichtungen 9 jeweils integral als Funktionseinheit ausgestaltet sind. Elektrische Eigenschaften der einzelnen Verbindungseinrichtungen 5 sind jeweils verschieden ausgestaltet. Hier ist eine der Verbindungseinrichtungen 5 mit einem Strom bis zu 100 A und die andere Verbindungseinrichtung 5 mit einem Strom bis 1 A beaufschlagbar. Entsprechend sind die elektrischen Eigenschaften der Verbindungseinrichtungen 5, also beispielsweise die Leitungsbeläge wie Widerstandsbelag, Ableitungsbelag, Kapazitätsbelag und/oder Induktivitätsbelag, der einzelnen Verbindungseinrichtungen 5 derart gewählt, dass die Signalverfälschung aufgrund ihrer parasitären Eigenschaften bei Beaufschlagung mit unterschiedlichen Simulationssignalen unterschiedlich ist. Die Spannungsfestigkeit der Verbindungseinrichtungen 5 beträgt in der hier vorliegenden Ausführungsform beispielhaft 60 V.

Wie in Fig. 1 weiter dargestellt ist, umfassen die Verbindungseinrichtungen 5 jeweils eine Mehrzahl Schalteinrichtungen 9, um eine elektrische Verbindung zwischen der Mehrzahl Testeinrichtungen 4 zu unterbrechen bzw. zu verbinden. Die Schalteinrichtungen 9 umfassen hier für jeden elektrischen Leiter 8 der Verbindungseinrichtung 5 einen Einzelschalter 10. Dabei sind elektrische Eigenschaften jeder Schalteinrichtung 9 an elektrische Eigenschaften der mit der Schalteinrichtung 9 verbundenen Verbindungseinrichtung 5 angepasst, wie oben ausgeführt.

Die Schalteinrichtungen 9 im Bereich der parallelen Verbindungseinrichtungen 5 sind in Schalteinheiten 11 zusammengefasst und gemeinsam über ein Schaltsignal schaltbar.

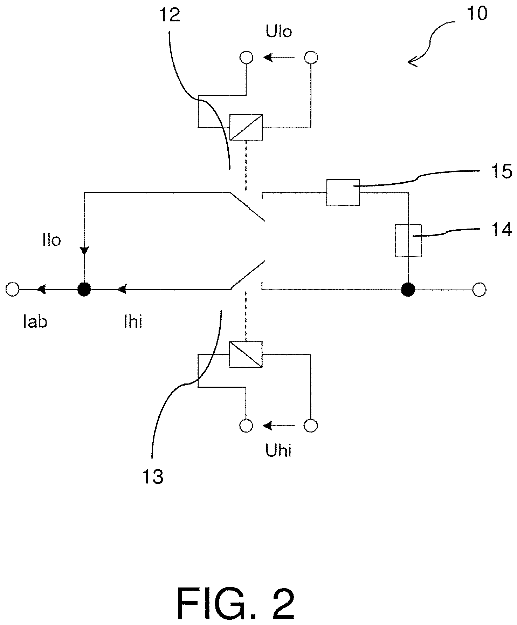

Wie in Fig. 2 bis 5 gezeigt, umfasst jeder Einzelschalter 10 eine Parallelschaltung einer Mehrzahl Schaltelemente 12, 13. In Fig. 2 ist ein Einzelschalter 10 mit einem Schaltelement 12 zum Durchleiten von kleinen Signalen und einem Schaltelement 13 zum Durchleiten von großen Signalen ausgeführt. Beide Schaltelemente 12, 13 sind hier als elektromechanische Schalter, beispielsweise als Schütz 13 und Relais 12, ausgeführt. Die Vorrichtung ist ausgeführt, beide Schaltelemente 12, 13 eines Einzelschalters gemeinsam zu steuern, d.h. gemeinsam zu öffnen oder zu schließen.

In einem Strompfad des vorzugsweise als Relais ausgestalteten Schaltelements 12 zum Durchleiten von kleinen Signalen sind zusätzlich ein Strombegrenzungselement 14 und einen Widerstand 15 angeordnet. Dieser Widerstand 15 und/oder das vorzugsweise als Sicherung ausgestaltete Strombegrenzungselement 14 ist vorzugsweise derart dimensioniert, dass selbst ein Highlevel-Signal keine Überlastung des Relais 12 herbeiführt.

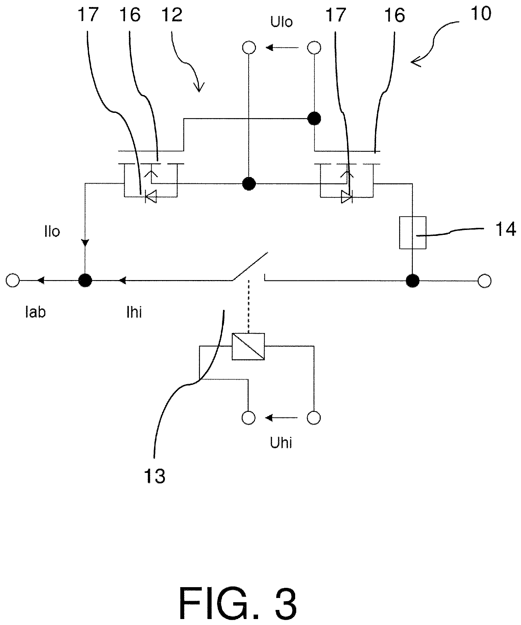

Ein Einzelschalter 10 gemäß einer ersten abgewandelten Ausführungsform ist in Fig. 3 gezeigt. Der Einzelschalter 10 der ersten abgewandelten Ausführungsform ist im Wesentlichen identisch zu dem unter Bezug auf die erste Ausführungsform beschriebenen, sodass für gleichartige Komponenten identische Bezugszeichen verwendet werden.

Der Einzelschalter 10 gemäß der ersten abgewandelten Ausführungsform unterscheidet sich von dem zuvor beschriebenen dadurch, dass Schaltelement 12 zum Durchleiten von kleinen Signalen als Halbleiterschalter ausgeführt ist.

Das Schaltelement 12 zum Durchleiten von kleinen Signalen umfasst eine Reihenschaltung aus zwei baugleichen MOSFETs 16, die jeweils mit einer Body-Diode 17 ausgeführt sind. Die Durchlassrichtung der Body-Dioden 17 der beiden MOSFETs 16 ist in der Reihenschaltung entgegengesetzt zu einander.

Als weiterer Unterschied fehlt bei dem Einzelschalter der ersten abgewandelten Ausführungsform der Widerstand 15.

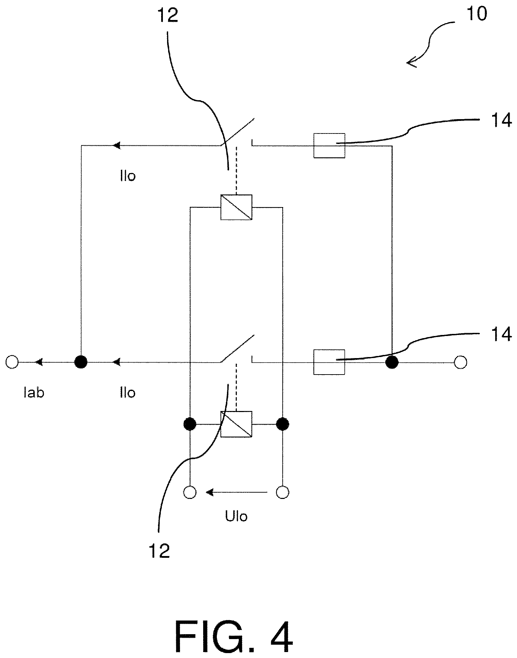

Ein Einzelschalter 10 gemäß einer zweiten abgewandelten Ausführungsform ist in Fig. 4 gezeigt. Der Einzelschalter 10 der zweiten abgewandelten Ausführungsform ist im Wesentlichen identisch zu dem unter Bezug auf die erste Ausführungsform beschriebenen, sodass für gleichartige Komponenten identische Bezugszeichen verwendet werden.

Der Einzelschalter 10 gemäß der zweiten abgewandelten Ausführungsform unterscheidet sich von dem zuvor beschriebenen dadurch, dass er eine Parallelschaltung aus zwei Schaltelementen 12, die beispielsweise als Relais für Lowlevel-Signale ausgestaltet sind, zum Durchleiten von kleinen Signalen umfasst. Der Einzelschalter 10 umfasst weiterhin zwei Strombegrenzungselemente 14, von denen jedem der Schaltelemente 12 zum Durchleiten von kleinen Signalen eines zugeordnet ist. Der Einzelschalter 10 ist ausgeführt, eine im Wesentlichen gleichmäßige Verteilung eines Signalstroms auf die Mehrzahl Schaltelemente 12 zum Durchleiten von kleinen Signalen zu bewirken.

Als weiterer Unterschied fehlt bei dem Einzelschalter der zweiten abgewandelten Ausführungsform der Widerstand 15. In der Ausführungsform gemäß Fig. 4 ist jedes einzelne der beiden - vorzugsweise gleichartigen - Schaltelemente 12 zum Durchleiten von Lowlevel-Signalen vorgesehen und eingerichtet, und mittels der gleichmäßigen Verteilung des Signalstromes auf diese beiden Schaltelemente 12 ergibt sich durch Summenbildung der Teilströme durch diese Schaltelemente 12 im Ergebnis, dass neben einem Lowlevel-Signal auch ein Highlevel-Signal durch die Parallelschaltung durchleitbar ist. Dadurch entfällt in Fig. 4 die Veranlassung aus Fig. 2, mittels Widerstand 15 eine Ungleichverteilung des Signalstromes über die beiden Schaltelemente herbeizuführen.

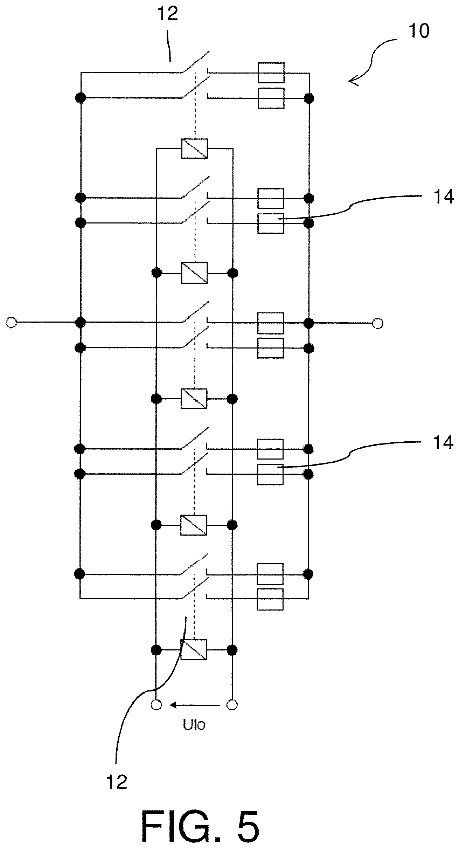

Ein Einzelschalter 10 gemäß einer dritten abgewandelten Ausführungsform ist in Fig. 5 gezeigt. Der Einzelschalter 10 der dritten abgewandelten Ausführungsform ist im Wesentlichen identisch zu dem unter Bezug auf die zweite abgewandelte Ausführungsform in Fig. 4 beschriebenen, sodass für gleichartige Komponenten identische Bezugszeichen verwendet werden.

Der Einzelschalter 10 gemäß der dritten abgewandelten Ausführungsform unterscheidet sich von dem zuvor beschriebenen dadurch, dass er eine Parallelschaltung aus fünf Schaltelementen 12 zum Durchleiten von kleinen Signalen umfasst. Jedes Schaltelement 12 ist als Tyco Schrack RT425024 Doppelwechsler mit zwei einzelnen Schaltkontakten ausgeführt. Entsprechend weisen die fünf Schaltelemente 12 zehn Schaltkontakte auf, die einen Dauerstrom von bis zu 80Aeff ermöglichen. Die Ansteuerleistung liegt bei ca. 2 Watt.

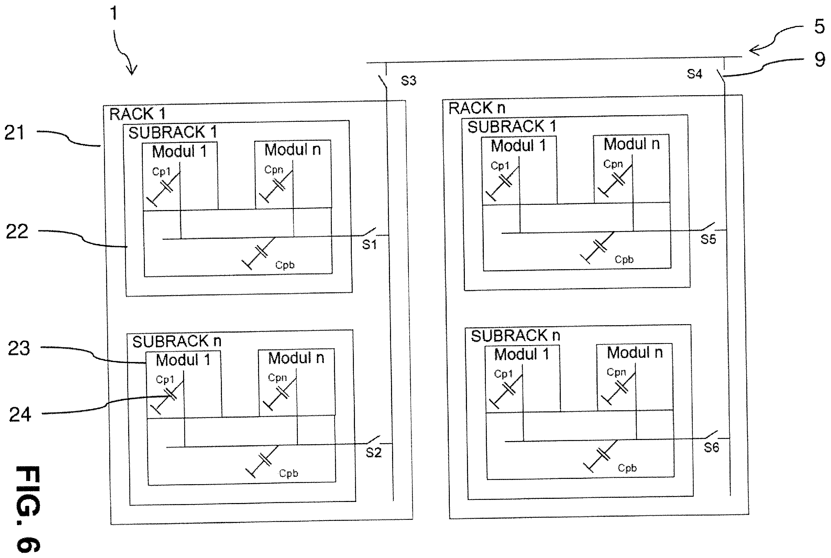

Eine Vorrichtung 1 gemäß einer zweiten Ausführungsform ist in Fig. 6 gezeigt. Die Vorrichtung 1 der zweiten Ausführungsform ist im Wesentlichen identisch zu derjenigen der ersten Ausführungsform, sodass für gleichartige Komponenten identische Bezugszeichen verwendet werden. Insbesondere zeigt Fig. 6 ein Beispiel einer konkreten Implementierung der Vorrichtung 1.

Wie in Fig. 6 gezeigt ist, umfasst die Vorrichtung 1 ein Mehrzahl Racks 21, die als sogenannter 19-Zoll-Schrank als Träger von Subracks 22 ausgeführt sind. Die Subracks 22 sind als sogenannte 19-Zoll-Baugruppenträger mit oder ohne Steckkontakte für mit dem 19-Zoll-Baugruppenträger verbundene und vorzugsweise austauschbare Module 23 bzw. Leiterplatten ausgeführt. Jedes Subrack 22 umfasst eine Mehrzahl Module 23, die hier jeweils als Eingabe- und AusgabeModul, das oft abgekürzt als I/O-Modul bezeichnet wird, wie beispielsweise ein Modul zur Signalmessung oder ein Modul zur Signalerzeugung ausgeführt sind. Parasitäre Kapazitäten 24 sind in Fig. 6 gegen Masse dargestellt.

Racks 21, Subracks 22 und Module 23 sind hier beispielhaft über eine Verbindungseinrichtung 5 miteinander Verbindbar. Racks 21, Subracks 22 und Module 23 bilden dabei Hierarchieebenen. Schalteinrichtungen 9 sind so angeordnet, um die Verbindung jeweils zwischen zwei Ebenen 21, 22, 23 zu unterbrechen bzw. zu verbinden.

Eine gleichzeitige und unabhängige Fehlersimulation in Rack 1 und Rack n ist gemäß der Vorrichtung des zweiten Ausführungsbeispiels gewährleistet. Zum Beispiel ist ein Kurzschluss von Signalen von Rack 1, Subrack 1, Modul 1 zu Rack 1 Subrack n Modul 1 und gleichzeitig von Rack n Subrack 1 Modul 1 zu Rack n Subrack n Modul 1 möglich. Entsprechend sind Schalteirichtungen 9 mit den Bezeichnungen S1, S2, S5 und S6 geschlossen, während Schalteinrichtungen 9 mit den Bezeichnungen S3 und S4 geöffnet sind.

**Bezugszeichenliste**

| | |
|---|---|
| Vorrichtung | 1 |
| Simulationseinrichtung | 2 |
| Routingeinrichtung | 3 |
| Testeinrichtung | 4 |
| Verbindungseinrichtung | 5 |
| gestrichelte Linie | 7 |
| elektrischer Leiter | 8 |
| Schalteinrichtung | 9 |
| Einzelschalter | 10 |
| Schalteinheit | 11 |
| Schaltelement, kleine Signale | 12 |
| Schaltelement, große Signale | 13 |
| Strombegrenzungselement | 14 |
| Widerstand | 15 |
| MOSFET | 16 |
| Body-Diode | 17 |
| elektrische Komponente, Steuergerät | 20 |
| Rack, Hierarchieebene | 21 |
| Subrack, Hierarchieebene | 22 |
| Modul, Hierarchieebene | 23 |
| Parasitäre Kapazität | 24 |

## Patentansprüche

1. Vorrichtung (1) zum Testen einer elektrischen Komponente, mit einer Simulationseinrichtung (2) zum Erzeugen eines Simulationssignals, einer Mehrzahl Testeinrichtungen (4), und einer Mehrzahl elektrischer Verbindungseinrichtungen (5), wobei die Simulationseinrichtung (2) und die Mehrzahl Testeinrichtungen (4) mit den Verbindungseinrichtungen (5) elektrisch leitend verbunden oder verbindbar sind, wobei die Verbindungseinrichtungen (5) jeweils wenigstens eine elektrische Schalteinrichtung (9) aufweisen, die derart angeordnet sind, um eine elektrische Verbindung zwischen der Mehrzahl Testeinrichtungen (4) über die entsprechende Verbindungseinrichtung (5) zu unterbrechen bzw. zu verbinden, wobei die Verbindungseinrichtungen (5) und die Schalteinrichtungen (9) jeweils integral als eine Funktionseinheit ausgestaltet sind, und wobei die Mehrzahl elektrischer Verbindungseinrichtungen (5), sich hinsichtlich jeweils wenigstens einer elektrischen Eigenschaft voneinander unterscheiden, und die Vorrichtung (1) eine Auswahleinrichtung zum Auswählen einer elektrischen Verbindung der Simulationseinrichtung (2) und der Mehrzahl Testeinrichtungen (4) mit einer der Verbindungseinrichtungen (5) umfasst.

2. Vorrichtung (1) nach Anspruch 1, **dadurch gekennzeichnet, dass** eine Mehrzahl elektrische Schalteinrichtungen (9) der Mehrzahl Verbindungseinrichtungen (5) gemeinsam als Schalteinheit (11) ausgeführt sind.

3. Vorrichtung (1) nach Anspruch 2, **dadurch gekennzeichnet, dass** die wenigstens eine Schalteinrichtung (9) zumindest eine elektrische Eigenschaft aufweist, die an zumindest eine elektrische Eigenschaft der mit der Schalteinrichtung (9) verbundenen Verbindungseinrichtung (5) angepasst ist.

4. Vorrichtung (1) nach einem der vorhergehenden Ansprüche, **dadurch gekennzeichnet, dass** die Vorrichtung (1) ausgeführt ist, die wenigstens eine Schalteinrichtung (9) lastfrei und/oder spannungsfrei zu schalten.

5. Vorrichtung (1) nach einem der vorhergehenden Ansprüche, **dadurch gekennzeichnet, dass** die wenigstens eine elektrische Verbindungseinrichtung (5) hierarchisch in wenigstens zwei Ebenen (21, 22, 23) angeordnet ist, und die wenigstens eine Schalteinrichtung (9) angeordnet ist, eine Verbindung zwischen zwei Ebenen (21, 22, 23) zu unterbrechen bzw. zu verbinden.

6. Vorrichtung (1) nach einem der vorhergehenden Ansprüche, **dadurch gekennzeichnet, dass** die wenigstens eine Schalteinrichtung (9) einen Halbleiterschalter umfasst.

7. Vorrichtung (1) nach einem der vorhergehenden Ansprüche, **dadurch gekennzeichnet, dass** die wenigstens eine Schalteinrichtung (9) einen elektromechanischen Schalter aufweist.

8. Vorrichtung (1) nach einem der vorhergehenden Ansprüche, **dadurch gekennzeichnet, dass** wenigstens eine Testeinrichtung (4) mit einem elektronischen Steuergerät (20) verbunden ist.

9. Vorrichtung (1) nach einem der vorhergehenden Ansprüche, **dadurch gekennzeichnet, dass** die wenigstens eine Schalteinrichtung (9) eine Parallelschaltung einer Mehrzahl Schaltelemente (12, 13) aufweist.

10. Vorrichtung (1) nach Anspruch 9, **dadurch gekennzeichnet, dass** die Vorrichtung (1) ausgeführt ist, die Schaltelemente (12, 13) einer Schalteinrichtung (9) gemeinsam zu steuern.

11. Vorrichtung (1) nach einem der Ansprüche 9 oder 10, **dadurch gekennzeichnet, dass** die wenigstens eine Schalteinrichtung (9) ein Schaltelement (12) zum Durchleiten von kleinen Signalen aufweist.

12. Vorrichtung (1) nach Anspruch11, **dadurch gekennzeichnet, dass** die wenigstens eine Schalteinrichtung (9) eine Mehrzahl von Schaltelementen (12) zum Durchleiten von kleinen Signalen aufweist.

13. Vorrichtung (1) nach Anspruch 12, **dadurch gekennzeichnet, dass** die wenigstens eine Schalteinrichtung (9) ausgeführt ist, eine gleichmäßige Verteilung oder eine im Wesentlichen gleichmäßige Verteilung eines Signalstroms auf die Mehrzahl Schaltelemente (12) zu bewirken.

14. Vorrichtung (1) nach einem der Ansprüche 9 bis 13, **dadurch gekennzeichnet, dass** die wenigstens eine Schalteinrichtung (9) ein Schaltelement (13) zum Durchleiten von großen Signalen aufweist.

15. Vorrichtung (1) nach Anspruch 11 in Verbindung mit Anspruch 14, **dadurch gekennzeichnet, dass** die wenigstens eine Schalteinrichtung (9) ein Schaltelement (12) zum Durchleiten von kleinen Signalen und ein Schaltelement (13) zum Durchleiten von großen Signalen aufweist.

16. Vorrichtung (1) nach einem der Ansprüche 9 bis 15, **dadurch gekennzeichnet, dass** wenigstens ein Schaltelement (12, 13) einen Halbleiterschalter umfasst.

17. Vorrichtung (1) nach einem der Ansprüche 9 bis 16, **dadurch gekennzeichnet, dass** wenigstens ein Schaltelement (12, 13) als elektromechanischer Schalter ausgeführt ist.

## Claims

1. A device (1) for testing an electrical component, having a simulation device (2) for generating a simulation signal, a plurality of test devices (4), and a plurality of electrical connection devices (5), the simulation device (2) and the plurality of test devices (4) being electrically conductively connected to or connectable to the connection devices (5), the connection devices (5) each comprising at least one electrical switch device (9) disposed for interrupting or connecting an electrical connection between the plurality of test devices (4) by means of the connection device (5), the connection devices (5) and the switch devices (9) each being implemented integrally as one functional unit, and the plurality of electrical connection devices (5) differing from each other with respect to at least one electrical property, and the device (1) comprising a selector device for selecting one electrical connection of the simulation device (2) and the plurality of test devices (4) by means of one of the connection devices (5).

2. The device (1) according to claim 1, **characterized in that** a plurality of electrical switch devices (9) of the plurality of connection devices (5) are implemented jointly as a switching unit (11).

3. The device (1) according to claim 2, **characterized in that** the at least one switch device (9) comprises at least one electrical property adapted to at least one electrical property of the connection device (5) connected to the switch device (9).

4. The device (1) according to any one of the preceding claims, **characterized in that** the device (1) is implemented for disconnecting the at least one switch device (9) from a load and/or voltage.

5. The device (1) according to any one of the preceding claims, **characterized in that** the at least one electrical connection device (5) is disposed hierarchally in at least two levels (21, 22, 23) and the at least one switch device (9) is disposed for interrupting or connecting a connection between two levels (21, 22, 23).

6. The device (1) according to any one of the preceding claims, **characterized in that** the at least one switch device (9) comprises a semiconductor switch.

7. The device (1) according to any one of the preceding claims, **characterized in that** the at least one switch device (9) comprises an electromechanical switch.

8. The device (1) according to any one of the preceding claims, **characterized in that** at least one test device (4) is connected to an electronic control device (20).

9. The device (1) according to any one of the preceding claims, **characterized in that** the at least one switch device (9) comprises a parallel circuit of a plurality of circuit elements (12, 13).

10. The device (1) according to claim 9, **characterized in that** the device (1) is implemented for jointly controlling the circuit elements (12, 13) of a switch device (9).

11. The device (1) according to any one of the claims 9 or 10, **characterized in that** the at least one switch device (9) comprises a circuit element (12) for passing on small signals.

12. The device (1) according to claim 11, **characterized in that** the at least one switch device (9) comprises a plurality of circuit elements (12) for passing on small signals.

13. The device (1) according to claim 12, **characterized in that** the at least one switch device (9) is implemented for bringing about uniform distribution or substantially uniform distribution of a signal current across the plurality of circuit elements (12).

14. The device (1) according to any one of the claims 9 through 13, **characterized in that** the at least one switch device (9) comprises a circuit element (13) for passing on large signals.

15. The device (1) according to claim 11 in conjunction with claim 14, **characterized in that** the at least one switch device (9) comprises a circuit element (12) for passing on small signals and a circuit element (13) for passing on large signals.

16. The device (1) according to any one of the claims 9 through 15, **characterized in that** at least one circuit element (12, 13) comprises a semiconductor switch.

17. The device (1) according to any one of the claims 9 through 16, **characterized in that** at least one circuit element (12, 13) is implemented as an electromechanical switch.

## Revendications

1. Dispositif (1) pour tester un composant électrique, avec un dispositif de simulation (2) pour générer un signal de simulation, une multitude de dispositifs de test (4) et une multitude de dispositifs de raccordement électriques (5), dans lequel le dispositif de simulation (2) et la multitude de dispositifs de test (4) sont ou peuvent être raccordés de manière électriquement conductrice avec les dispositifs de raccordement (5), dans lequel les dispositifs de raccordement (5) comportent respectivement au moins un dispositif de commutation (9) électrique, qui sont disposés de manière à interrompre ou à empêcher une liaison électrique entre la multitude de dispositifs de test (4) via le dispositif de raccordement (5) correspondant, et dans lequel les dispositifs de raccordement (5) et les dispositifs de commutation (9) se présentent respectivement intégralement sous la forme d'une unité fonctionnelle, et dans lequel la multitude de dispositifs de raccordement (5) électriques diffèrent les uns des autres en termes, respectivement, d'au moins une propriété électrique, et le dispositif (1) comprend un dispositif de sélection pour la sélection d'une liaison électrique du dispositif de simulation (2) et de la multitude de dispositifs de test (4) avec l'un des dispositifs de raccordement (5).

2. Dispositif (1) selon la revendication 1, **caractérisé en ce qu'**une multitude de dispositif de commutation (9) de la multitude de dispositifs de raccordement (5) sont exécutés communément en tant qu'unité de commutation (11).

3. Dispositif (1) selon la revendication 2, **caractérisé en ce que** l'au moins un dispositif de commutation (9) présente au moins une propriété électrique qui est adaptée à au moins une propriété électrique du dispositif de raccordement (5) relié avec le dispositif de commutation (9).

4. Dispositif (1) selon l'une des revendications précédentes, **caractérisé en ce que** le dispositif (1) est exécuté pour commuter l'au moins un dispositif de commutation (9) à l'état sans charge et/ou sans tension.

5. Dispositif (1) selon l'une des revendications précédentes, **caractérisé en ce que** l'au moins un dispositif de raccordement (5) électrique est disposé de manière hiérarchique sur au moins deux niveaux (21, 22, 23) et l'au moins un dispositif de commutation (9) est disposé de manière à interrompre ou à empêche une liaison entre deux niveaux (21, 22, 23).

6. Dispositif (1) selon l'une des revendications précédentes, **caractérisé en ce que** l'au moins un dispositif de commutation (9) comporte un interrupteur à semi-conducteurs.

7. Dispositif (1) selon l'une des revendications précédentes, **caractérisé en ce que** l'au moins un dispositif de commutation (9) comporte un interrupteur électromécanique.

8. Dispositif (1) selon l'une des revendications précédentes, **caractérisé en ce que** l'au moins un dispositif de test (4) est relié à un appareil de commande (20) électrique.

9. Dispositif (1) selon l'une des revendications précédentes, **caractérisé en ce que** l'au moins un dispositif de commutation (9) comporte un couplage en parallèle d'une multitude d'éléments de commutation (12, 13).

10. Dispositif (1) selon la revendication 9, **caractérisé en ce que** le dispositif (1) est exécuté pour commander communément les éléments de commutation (12, 13) d'un dispositif de commutation (9).

11. Dispositif (1) selon l'une des revendications 9 ou 10, **caractérisé en ce que** l'au moins un dispositif de commutation (9) comporte un élément de commutation (12) pour transférer de petits signaux.

12. Dispositif (1) selon la revendication 1, **caractérisé en ce que** l'au moins un dispositif de commutation (9) comporte une multitude d'éléments de commutation (12) pour transférer de petits signaux.

13. Dispositif (1) selon la revendication 12, **caractérisé en ce que** l'au moins un dispositif de commutation (9) est exécuté pour réaliser une répartition uniforme ou une répartition substantiellement uniforme d'un courant de signal sur la multitude d'éléments de commutation (12).

14. Dispositif (1) selon l'une des revendications 9 à 13, **caractérisé en ce que** l'au moins un dispositif de commutation (9) comporte un élément de commutation (13) pour transférer de grands signaux.

15. Dispositif (1) selon la revendication 11 en relation avec la revendication 14, **caractérisé en ce que** l'au moins un dispositif de commutation (9) comporte un élément de commutation (12) pour transférer de petits signaux et un élément de commutation (13) pour transférer de grands signaux.

16. Dispositif (1) selon l'une des revendications 9 à 15, **caractérisé en ce qu'**un élément de commutation (12, 13) comporte un interrupteur à semi-conducteurs.

17. Dispositif (1) selon l'une des revendications 9 à 16, **caractérisé en ce qu'**un élément de commutation (12, 13) au moins comporte un interrupteur électromécanique.
